Europäisches Patentamt

European Patent Office

Office européen des brevets

(19)

(11) Numéro de publication: **0 017 563**
**B1**

(12) **FASCICULE DE BREVET EUROPEEN**

(45) Date de publication du fascicule du brevet: **15.02.84**

(51) Int. Cl.³: **G 03 F 7/08, G 03 F 7/10**

(21) Numéro de dépôt: **80400404.2**

(22) Date de dépôt: **26.03.80**

(54) **Article pour la réalisation d'auxiliaires visuels comportant un support transparent et revêtu d'une composition photopolymérisable.**

(30) Priorité: **28.03.79 FR 7907747**

(43) Date de publication de la demande:
**15.10.80 Bulletin 80/21**

(45) Mention de la délivrance du brevet:
**15.02.84 Bulletin 84/7**

(84) Etats contractants désignés:
**AT BE CH DE GB IT LU NL SE**

(56) Documents cités:
CH - A - 440 975
DE - A - 1 797 282
DE - A - 2 339 035
DE - A - 2 551 347
FR - A - 2 011 413
FR - A - 2 087 414
FR - A - 2 098 757
FR - A - 2 101 639
FR - A - 2 312 800
US - A - 3 829 369
RESEARCH DISCLOSURE, no. 169, mai 1978
HOMEWELL, HAVANT HAMPSHIRE (UK) H.G.
McGUCKIN et al.: "Continuous tone dyed diazo
imaging elements", pages 62-66, Disclosure no.
16976

(73) Titulaire: **RHONE-POULENC SYSTEMES**
**47, rue de l'Echat**
**F-94000 Creteil (FR)**

(72) Inventeur: **Pigeon, Marcel**
**64, rue de Longchamp**
**F-92200 Neuilly (FR)**
Inventeur: **Szretter, Marta**
**6, rue de Longpont**
**F-92200 Neuilly (FR)**
Inventeur: **Perie, Chantal**
**71, rue Championnet**
**75018 Paris (FR)**

(74) Mandataire: **Chichery, Guy**
**RHONE-POULENC RECHERCHES Centre de**
**Recherches de Saint-Fons Service Brevets B.P. 62**
**F-69190 Saint-Fons (FR)**

Courier Press, Leamington Spa, England.

Article pour la réalisation d'auxiliaires visuels comportant un support transparent
et revêtu d'une composition photopolymérisable

La présente invention concerne des articles pour la realisation d'auxiliaires visuels comportant un support transparent et revêtu d'une composition photopolymérisable négative ces auxiliaires visuels pouvant être des films de montage, de contretypage, des guides de couleurs, des films pour microfiches, etc...

Elle se rapporte plus particulièrement à un article pour la réalisation d'auxiliaires visuels comportant un support transparent revêtu d'une composition photopolymérisable négative, soluble dans les solvants organiques, constituée (I) d'une résine époxy et (2) d'un produit de réaction photosensible soluble dans les solvants organiques mais peu soluble dans l'eau de (a) un produit de concensation photosensible et hydrosoluble d'un composé de diazonium et d'un agent de condensation organique et (b) d'un agent de couplage organique destiné à rendre le produit soluble dans les solvants organiques.

De tels articles sont particulièrement utiles dans la technique d'impression planographique.

Les films de montage sont destinés à l'obtention d'un film de base servant de repérage pour le montage et le positionnement des différentes couleurs. Généralement, ces films donnent par insolation une couleur bleue peu soutenue. Ces films sont inactiniques vis-à-vis des rayons U.V. et les films de sélection de couleur peuvent être montés et copiés sans interférence avec le film de montage.

Les films "guide de couleur" ( ou de sélection de couleurs), sont des films dans les trois couleurs complémentaires cyan, magenta et jaune qui par superposition sur fond blanc, permettent de se rendre compte de la couleur finale que l'on obtiendra après impression lithographique polychrome. Ces mêmes épreuves en couleurs peuvent d'ailleurs être réalisées dans une grande variété de couleurs et sont dans ce cas, utilisables par exemple en rétroprojection.

Les films de contretypage du type "Arts Graphiques" tels que ceux vendus par la Société DUPONT DE NEMOURS sous la marque CRONA-LITE sont des films de contretypage trait et trame ayant une densité assez élevée et absorbant l'ultra-violet. Ces films sont généralement noirs.

Les films pour microfiches sont des films de couleur noir-marron assez denses de façon à pouvoir lire l'information microcopiée avec un bon contraste.

Dans toutes ces applications, le support utilisé est transparent et de préférence en matière plastique souple.

Des films du type "guide de couleur" sont décrits dans le brevet français n° 2 011 413, en particulier dans l'exemple 17.

De tels films sont développés, après insolation aux ultraviolets à travers un original tramé présentant des zones transparentes et des zones opaques, à l'aide d'une solution aqueuse contenant 20% d'agent mouillant tel que le laurylsulfate de sodium. Pour obtenir un bon développement sans détériorer la couche, il est toutefois préférable d'ajouter à la solution de développement un peu d'acide.

La composition ainsi enduite sur le support transparent en polyester est constituée par une solution dans le méthylcellosolve de 5% d'un produit de condensation de la p.diazodiphényl-amine avec le paraformaldéhyde couplé avec l'acide 2 hydroxy 4 méthoxy benzophénone 5 sulfonique et 2% d'une résine époxy "EPON 1031" de la Société SHELL CHEMICAL COMPANY.

Tous les articles énumérés ci-dessus sont généralement manipulés sans précaution particulière et il est nécessaire d'utilisier des couches photosensibles ayant une bonne résistance à l'abrasion, c'est-à-dire ayant une bonne dureté et une bonne ténacité. Dans ce but, les couches photosensibles à base de résine époxy conviennent bien.

Les couches photosensibles telles que décrites précédemment appliquées à la réalisation d'articles tels que définis ci-dessus présentent toutefois l'inconvénient de nécessiter des révélateurs spéciaux. Le but de la présente invention est de réaliser des auxiliaires visuels développables à l'eau.

La présente invention est caractérisée en ce que:

A: la résine époxy est un monomère ou un préplymère fluide à température ambiante ayant un point de fusion déterminé selon la méthode de Durran inférieur ou égal à 38°C.

B: l'agent de couplage organique est choisi de telle manière que le produit de réaction photosensible précipite au cours de sa préparation en milieu aqueux sous forme de pâte, ce qui entraîne une légère solubilité dans l'eau du produit de réaction.

La composition photopolymérisable est exposée sélectivement à la lumière ultraviolette, de façon à durcir les zones ainsi exposées, les zones non exposées étant enlevées avec de l'eau.

On a en effet constaté, de manière surprenante, qu'en utilisant des compositions photopolymérisables contenant des produits de réaction photosensibles de préférence dérivés d'un composé de diazonium aromatique, tels que décrits ci-dessus et une résine époxy fluide à température ambiante, (la fluidité de la résine s'appréciant en l'absence de solvant) et en déposant celle-ci sur un support approprié, les zones exposées à la lumière actinique durcissent, tandis que les zones non exposées peuvent être enlevées par simple rinçage à l'eau courante.

Une telle particularité présente un intérêt pratique très important puisque l'on supprime ainsi l'utilisation de solvants ou de solutions aqueuses contenant un agent mouillant pour le développement desdites compositions. Ainsi, un auxiliaire visuel revêtu d'une couche d'une composition photopolymérisable telle que décrite ci-dessus peut être insolé, développé et séché en quelques minutes.

Selon un mode préférentiel de réalisation, les auxiliaires visuels selon l'invention comportent une composition photopolymérisable négative dans laquelle les résines époxy utilisées ont un équivalent époxy inférieur ou égal à 200. En effet, lorsque l'on veut obtenir une couche sensible ayant une bonne dureté, il est préférable d'avoir le plus grand nombre possible de groupements époxy dans un gramme de résine, celui-ci augmentant lorsque le nombre représentant l'équivalent époxy diminue: le terme équivalent époxy désigne, en effet, le poids en gramme de résine qui contient un équivalent gramme d'époxy. De préférence, on utilisera des résines époxy ayant une viscosité supérieure à 5.000 centipoises.

Lorsqu'on utilise des résines époxy fluides de viscosité inférieure à 5.000 centipoises, il devient dans certains cas difficile d'obtenir une couche photopolymérisable selon l'invention qui, après dépôt sur un support, soit non collante.

Le caractère de fluidité des résines utilisées dand le cadre de la présente invention peut être défini comme dans le brevet américain n° 3 794 574. Une méthode qui peut être utilisée pour définir la limite de fluidité des résines selon l'invention est, par exemple, la méthode DURRAN utilisant le mercure et dans laquelle on considère que le point de fusion d'une résine époxy est la température à laquelle la résine fondue atteint le sommet de mercure.

Cette méthode est décrite en détails dans l'ouvrage "ANALYTICAL CHEMISTRY OF POLYMERS " Part I — pages 155—156 — aux éditions GOIDON M. KLINE — INTER SCIENCE PUBLISHERS INC. — NEW YORK.

En utilisant cette méthode de mesure, on a constaté qu'il était préférable que les résines époxy utilisées dans la couche de la présente invention aient un point de fusion inférieur ou égal à environ 38°C. On constate toutefois, que l'on obtient dans ce cas, un développement à l'eau que pendant les quelques jours qui suivent l'enduction, tout en obtenant la plus grande finesse de traits avec les trames utilisées pour la reproduction d'une image. Par contre, lorsque le point de fusion selon la méthode de DURRAN de la résine epoxy utilisée, est inférieur ou égal à environ 27°C, le développement à l'eau de la composition photopolymérisable selon l'invention est possible pendant une dizaine de jours, dans les mêmes conditions que précédemment.

Pour obtenir un développement à l'eau après plusieurs dizaines de jours ou plusieurs mois de stockage de la composition photosensible (ce qui est souhaitable dans le cas d'articles présensibilisés) la Demanderesse a constaté qu'il était préférable d'utiliser des résines époxy ayant un point de fusion DURRAN inférieur ou égal à environ 20°C.

Sans pour autant être liée à une quelconque théorie, la Demanderesse pense qu'à l'intérieur des limites fixées ci-dessus pour la résine époxy, l'addition de produit de réaction photosensible augmente la viscosité de la composition photopolymérisable et permet ainsi d'obtenir une couche non collante.

D'une façon générale, ou trouvera une description détaillée sur les résines époxy dans les pages 312 à 329 du premier volume supplémentaire de "ENCYCLOPEDIA OF CHEMICAL TECHNOLOGY" édité par KIRK and OTHMER et publié par INTERSCIENCE ENCYCLOPEDIA INC — NEW YORK — 1975, ainsi qu'aux pages 340 à 528 du livre "Epoxy-verbinduengen und Epoxy harze" édité par PAQUIN et publié par SPRINGER-VERLAG — BERLIN — GOTTINGEN und HEIDELBERG — 1958. Les résines époxy convenant plus particulièrement dans le cadre de l'invention sont les éthers glycidiques du bisphénol A ainsi que les résines époxy novolaques phénol ou crésol. Parmi les éthers glycidiques du bisphénol A, la Demanderesse préfère utiliser les éthers diglycidiques.

De telles résines fluides à température ambiante peuvent être utilisées seules ou en mélanges, de façon à ajuster éventuellement leur viscosité.

On peut par exemple avantageusement dans certains cas particuliers, utiliser une résine époxy de viscosité inférieure à 5.000 centipoises en mélange avec une résine époxy de viscosité supérieure et obtenir ainsi un mélange pouvant être développé à l'eau pendent plusieurs mois ou années. On peut de même utiliser des mélanges comportant au moins une résine de viscosité inférieure à 5.000 centipoises et au moins une résine ayant un point de fusion DURRAN supérieur à 20°C et obtenir un mélange pouvant parfaitement être développé à l'eau plusieurs mois après son enduction sur un support. L'homme de l'art pourra ainsi réaliser toutes sortes de mélanges suivant le but recherché, lesdits mélanges étant compris dans le cadre de la présente invention.

Pour plus de détails concernant les caractéristiques et mode de préparation de telles résines époxy fluides, on pourra se reporter avantageusement au brevet US 3 794 576.

A titre non limitatif, les résines époxy liquides couramment disponibles dans le commerce et qui conviennent dans le cadre de la présente invention sont:

— dans les produits vendus par la Société CIBA GEIGY sous la marque ARALDITE, les références GY 255, GY 260, ainsi que les références EPN 1138 et EPN 1139,

— dans les produits vendus par la Société SHELL, sous les marques EPIKOTE ou EPON, les références 827, 828, 834, etc...

D'une façon générale, les composés de diazonium utilisables dans les compositions photopolymérisables selon l'invention, sont des produits photosensibles, à fonction négative, et hydrosolubles tels que les diazo aromatiques et plus particulièrement les diazo arylamines éventuellement substitués sur le noyau aromatique ou sur le groupe amino. De préférence, on utilisera la paradiazodiphénylamine. Ces composés de diazonium sont condensés avec des agents de condensation organique possédant des groupes carbonyles réactifs choisis de préférence parmi les aldéhydes ou les acétals. On peut citer en particulier, le formaldéhyde et le paraformaldéhyde. De tels produits et leur procédé de préparation sont décrits dans le brevet anglais n° 418 001.

Comme agents de couplage, on utilisera des produits permettant d'obtenir un produit de réaction photosensible, tel que défini ci-dessus, ayant une bonne solubilité dans les solvants organiques mais peu solubles dans l'eau.

Il est en efet très important que le produit de réaction photosensible soit légèrement soluble dans l'eau: on a en effet constaté que si ce produit était totalement insoluble dans l'eau, on ne pouvait obtenir un développement à l'eau de ladite composition photosensible. D'une manière générale, il est nécessaire d'utiliser des agents de couplage organiques qui tendent à diminuer le caractère ionique desdits composés de diazonium de façon à obtenir un produit de réaction soluble dans les solvants organiques et peu solubles dans l'eau.

Il est possible au cours de la préparation en milieu aqueux du produit de réaction de se rendre compte immédiatement si celui-ci convient ou non dans les compostions photopolymérisables de l'invention: lorsqu'on utilise un agent de couplage organique ayant un ou plusieurs substituants électro-négatifs forts, tels qu'un groupe nitré ou un halogène, on obtient un produit de réaction qui précipite immédiatement et que l'on peut filtrer facilement. Un tel produit n'est pas soluble dans l'eau et ne convient donc pas dans la cadre de la présente invention: apprès application sur un support, de telles compositions ne peuvent être développées qu'à l'aide d'une solution aqueuse d'acide.

Par contre, lorsque le produit de réaction est convenable, il précipite, au cours de la préparation sous forme d'une pâte qui doit être ensuite redissoute dans un solvant.

De préférence, on utilisera comme agent de couplage organique des acides arylsulfoniques et en particulier des acides alkylarylsulfoniques. Par alkyl, on entend une chaîne carbonée comportant moins de 10 atomes de carbone, éventuellement susbtituée.

De préférence, on utilisera un substituant choisi parmi l'hydrogène, les groupements méthyl et éthyl. Le terme aryl, quant à lui désigne un noyau aromatique simple ou condensé.

De préférence, on utilisera toutefois un noyau aromatique simple, car il est possible dans certains cas de ne pas obtenir un développement à l'eau très facile avec des noyaux aromatiques contensés. Par exemple, on a constaté que les acides mono ou poly-sulfoniques, du naphtalène, éventuellement substitués, ne conviennent pas très bien comme agent de couplage de la paradiazodiphényl-amine condensée formaldéhyde: le développe-ment à l'eau est dans ce cas précis, très difficile.

C'est pourquoi la Demanderesse préfère choisir comme agent de couplage les acides benzène sulfonique, toluène-sulfonique, et di-methyl benzène-sulfonique (de préférence l'acide 2,5 diméthyl benzène sulfonique).

La Demanderesse a également constaté que le choix du substituant sur le noyau aromatique de l'acide de couplage arylsulfonique avait une influence directe sur le comportement du sel et cet acide avec la paradiazodiphénylamine condensée avec un produit de condensation tel que défini auparavant ainsi que sur le développement de la composition photopolymérisable selon l'invention.

Sans vouloir être par une quelconque théorie, la Demanderesse considère que l'influence des substituants sur les groupes fonctionnels est représentée par l'équation:

$$\rho\sigma = \mathrm{Log}\, \frac{K}{K_o}$$

(équation de Hammett — Physical organic Chemistry — G. P. Hammett Mac Graw Hill — 1940)

équation dans laquelle $K_o$ et $K$ sont des constantes de vitesse de réaction, $\sigma$ est le coefficient de substituant et $\rho$ est le coefficient d'une réaction définie.

D'après cette équation, les substituants attracteurs d'électrons ont un coefficient $\sigma$ positif par rapport à l'hydrogène dont le coefficient est égal à zéro.

Les substituants donneurs d'électrons ont un coefficient négatif par rapport à l'hydrogène.

A titre indicatif, le tableau ci-dessous donne la valeur de $\sigma$ pour un certain nombre de substituants:

| Substituants | Valeur de $\sigma$ |
|---|---|
| H | O |
| p.Cl | +0,227 |
| p.Br | +0,232 |
| p. $NO_2$ | +0,778 |

| Substituants | Valeur de $\sigma$ |
|---|---|
| m.NO$_2$ | +0,710 |
| p.CH$_3$ | −0,170 |
| p.OC$_2$H$_5$ | −0,250 |
| p.OCH$_3$ | −0,268 |
| p.C$_2$H$_5$ | −0,151 |
| m.CH$_3$ | −0,069 |
| p.i.C$_3$H$_7$ | −0,151 |
| p.tert.C$_4$H$_9$ | −0,197 |
| 3,4 di(CH$_3$) | −0,229 |

Dans le cadre de la présente invention, la Demanderesse a constaté que le coefficient $\sigma$ des substituants qui conviennent est généralement négatif ou nul.

Pour préparer un produit de réaction photosensible convenant dans le cadre de la présente invention, tel que par exemple un dérivé de la paradiazodiphénylamine, on prépare tout d'abord un sel de paradiazodiphénylamine condensée avec un agent de condensation organique ayant des groupes carbonyls réactifs, selon l'enseignement du brevet anglais n° 418 011. De tels produits condensés avec le paraformaldéhyde sont couramment disponibles dans le commerce. On réalise ensuite une solution aqueuse du composé de diazonium ainsi condensé en présence d'acide. On ajoute alors à cette solution sous forte agitation, une solution d'acide arylsulfonique. Lorsque le produit de réaction photosensible obtenu precipite sous forme d'une pâte collante (le coefficient $\sigma$ du substituant de l'acide arylsulfonique utilisé étant alors négatif ou nul), ceci indique que ledit produit de réaction photosensible a une certaine solubilité dans l'eau et qu'il convient dans le cadre de la présente invention. Ladite pâte est alors séparée du milieu réactionnel, puis redissoute dans un solvant ce qui permet d'obtenir une solution stable plusieurs dizaines de jours. On peut obtenir le produit sous forme solide en précipitant la solution ci-dessus avec un solvant adéquat.

Lorsqu'on désire réaliser des auxiliaires visuels ayant une couche photosensible non collante à température ambiante, afin notamment de pouvoir toucher ladite couche sans la marquer ni la détériorer, il est recommandable de réaliser des compositions comportant de 40% à 70% en poids de produit de réaction photosensible et de 30% à 60% en poids de résine époxy.

La Demanderesse préfère que lesdites compositions comportent de 45% à 60% en poids de produit de réaction photosensible et de 40% à 55% en poids de résine époxy.

Afin de rendre visibles pour l'opérateur les parties de la couche ayant été réticulées, on peut incorporer dans la composition selon l'invention, un ou plusieurs indicateurs colorés susceptibles de se colorer en milieu acide. De référence, afin de ne pas gêner le développement à l'eau de ladite couche, on préférera le poids d'indicateur coloré à moins de 10% du poids de la composition photopolymérisable.

D'une façon générale, une quantité inférieure à 5% en poids convient parfaitement. Toutefois, dans la majorité des applications dans le cadre de la présente invention telle que revendiquée, ces indicateurs colorés seront remplacés par des colorants permanents définis ci-après. Pour obtenir, un développement facile à l'eau courante, il convient de ne pas déposer une couche trop importante de composition photopolymérisable selon l'invention.

On a constaté d'une manière générale, que l'on obtenait d'excellents résultats en déposant de 0,5 g/m2 à 2 g/m2 de couche photopolymérisable et de préférence de 1 g/m2 à 1,5 g/m2. Lorsqu'on dépose trop peu de composition photopolymérisable, on risque de ne pas avoir une couche suffisamment homogène et constante sur tout le support. Au-delà de 2 g/m2, il devient parfois difficile d'enlever la couche non exposée avec de l'eau seule.

Dans les couches photosensibles décrites ci-dessus, on incorporera tout type de colorants solubles dans les solvants. A titre non limitatif, on peut citer le trophénylméthane et ses dérivés tels que le bleu victoria et le violet de méthyl, les rhodamines, les jaunes d'alizarine, les réactifs colorés RAL de la Société UGINE-KULLMANN, les colorants "Néozapon" et "Sudan" de la Société BASF, les colorants ORASOL de la Société CIBA-GEIGY ainsi que les colorants CERES de la Société BAYER.

Dans le cas de films "guide de couleur", on utilisera de préférence pour obtenir les couleurs cyan, magenta et jaune, respectivement le bleu victoria, les rhodamines et les jaunes ORASOL de la Société CIBA-GEIGY.

Dans le cas des films de micropie, on peut avantageusement utiliser un mélange des rois couleurs ci-dessus.

Dans tous les cas, le poids total de colorant sera inférieur à 20% de la couche photosensible. De préférence, on limitera la quantité de colorant jaune à moins de 10% en poids par rapport au poids de la couche photosensible (en effet, le colorant jaune absorbant les ultraviolets, il est nécessaire de limiter le poids déposé pour avoir une réticulation de la couche photosensible dans les parties insolées). Pour les films du type "Arts Graphiques", il faut incorperer dans la couche des absorbeurs d'ultraviolets tels que les auramines, thio-flavines, jaunes naphtols, etc . . .

Dans tous les cas, la proportion d'absorbeur d'ultraviolet ne devra pas être supérieure à 5% du poids.

Le support utilisé, qui doit être transparent, peut être en verre mais de préférence en matière plastique scuple telle que le polyester, le polycarbonate, le polystyrène, les acétates de cellulose, de polyvinyle, le chlorure de polyvinyle, les polyoléfines, etc...

Lorsqu'on désire un auxiliaire visuel ayant une grande stabilité dimensionnelle, on utilisera de préférence un support en polytéréphtalate d'éthylène et plus généralement en polyester, ainsi qu'en polycarbonate.

D'une façon générale, afin d'obtenir un bon développement de l'auxiliaire visuel à l'eau seule, il est préférable d'utiliser un support substraté. Cette couche de substratage ne toit présenter aucune interaction avec la couche photosensible. En particulier, il est important dans certains applications des auxiliaires visuels sel on l'invention telles que celles notamment se rapportant à l'impression lithographique, que cette couche de substratage ne fixe pas les colorants de la couche photosensible, ce qui laisserait après développement un voile de fond coloré.

Un grand nombre de résines de susbtratage peuvent être utilisées dans la cadre de la présente invention telle que revendiquée. D'une manière générale, on peut citer les résines à base de polychlorure de vinylidène, les résines polyester, les résines acryliques, etc...

De préférence, on utilisera une résine de substratage à base de polymétacrylate d'alkyle, tel que le polymétacrylate de méthyle, éthyle, butyle, etc... seuls ou en mélanges, les résines époxy, les résines phénol ou crésol condensées avec un aldéhyde, les résines époxy novolaques phénol ou crésol, la gélatine durcie, etc... Le poids de substrat déposé sera inférieur à 1 g/m2 et de préférence 0,5 g/m2.

Avec la gélatine durcie, on constate de bons résultats: la couche photosensible est bien isolée du support et on ne constate aucune interaction entre cette couche et la résine époxy ou les colorants. Dans l'ensemble, les résultats obtenus sont bons, l'adhérence de la couche photosensible sur la couche de gélatine étant suffisante. Toutefois, on constate une légère coloration jaune de la gélatine lors du développement, la partie diazo non insolée colorant la couche de gélatine. Cette coloration disparait par réinsolation complète de l'auxiliaire visuel sous une lampe ultraviolette ou simplement après un temps plus long, à la lumière ambiante lors de l'examen dudit auxiliaire visuel.

Ce type de film revêtu d'une couche de substratage gélatinée présente l'avantage d'être disponible couramment dans le commerce puisqu'il s'agit des supports habituellement utilisés pour les films photo argentiques.

Les résines phénoplastes donnent également des résultats particulièrement intéressants. De préférence, on utilisera des résines phénol ou crésol condensées avec un aldéhyde et de préférence le paraformaldéhyde. De telles résines novolaques sont couramment disponibles dans le commerce. Ces résines ne présentent aucune réaction avec la couche photosensible. De plus, elles ne sont pas hydrophiles et elles n'absorbent donc pas le composé de diazonium lors du développement à l'eau. Le support reste donc incolore et l'opération de réinsolation n'est plus nécessaire comme avec la couche de substratage à base de gélatine durcie.

Les résines époxy sont particulièrement intéressantes dans le cadre de la présente invention telle que revendiquée comme couches de substratage, car elles donnent d'excellents résultats, dus probablement à la bonne comptabilité avec la couche photosensible qui comporte également des résines époxy. On peut choisir celles-ci parmi toutes les résines solides. En particulier, toute la série des résines EPIKOTE de la Société SHELL conviennent très bien, depuis la référence 1001 jusqu'à la référence 1031.

On peut également avantageusement utiliser les résines époxy novolaques crésol ou phénol.

L'invention sera mieux comprise à l'aide des exemples de réalisation suivants donnés à titre non limitatifs:

### Exemple 1
Film bleu:

On prépare une solution photosensible à 5% de solide dans le méthylcellosolve.

On dissout 2,5 g de résine époxy novolaque 1139 de CIBA, 0,25 g de colorant bleu victoria N.S.A. 1750 de la Société FRANCOLOR dans 55,25 g de méthylcellosolve, on y ajoute 42 g d'une solution de p.toluène sulfonate de p.diazodiphénylamine condensé formaldéhyde à 6% dans le méthylcellosolve.

On applique cette solution sur un film polyester substraté gélatine pour applications photographiques.

On enduit à l'aide d'une tournette à 50 t/mn pendant 30''; on sèche dans la tournette 5' à 40°C puis on sèche en étuve pendant 5' à 85°C.

On expose le film ainsi traité à travers un montage négatif sous une lampe à arc du type NUARC 2 KW distante de 60 cm pendant 3'. On developpe au jet d'eau, les parties non insolées gonflent et se dissolvent dans l'eau, on termine en frottant légèrement à l'aide d'un tampon.

On obtient une image positive bleue pouvant être utilisée comme film de montage. La coloration jaune uniforme du fond disparaît après exposition à la lumière.

### Exemple 2
Film rouge:

On prépare une solution photosensible à 5% de solide dans le méthylcellosolve. On dissout 2,5 g de résine époxy novolaque 1139 de la Société CIBA GEIGY, 0,125 g de colorant Rhodamine B extra de la Société CIBA GEIGY et 0,125 g de colorant Rhodamine 6 G extra de la Société CIBA GEIGY 55,25 g de méthylcellosolve: on y ajoute 42 g de solution de p.toluène sulfonate de p.diazo diphénylamine condensé formaldéhyde à 6% dans le méthylcellosolve. On applique cette solution sur le même support que l'exemple précédent, et de la même façon.

On expose le film ainsi traité comme décrit dans l'exemple précédent: on obtient une image visible rouge-violette (visible dans les parties insolées).

Après développement au jet d'eau, on obtient un positif rouge magenta pouvant servir de film test de guide de couleur. Afin d'éliminer la coloration jaune du fond, une réexposition totale du film à la lumière blanche est nécessaire.

### Exemple 3

Film jaune:

On prépare dans les mêmes conditions que l'exemple 1 une solution photosensible à 5% de solide dans le méthylcellosolve. On remplace le colorant bleu par un colorant jaune ORASOL GRLN de la Société CIBA GEIGY. On applique cette solution sur le même support et dans les mêmes conditions que dans l'exemple 1.

On expose et on développe dans les mêmes conditions que dans l'exemple 1. On obtient une image positive jaune pouvant être utilisée comme film test de guide de couleur.

### Exemple 4

Film bleu:

On prépare une solution photosensible à 5% de solide dans le méthylcellosolve. On dissout 2,5 g de résine époxy novolaque 1139 de la Société CIBA GEIGY, 0,25 g de bleu victoria BRN de BASF dans 55,5 g de méthylcellosolve.

On y ajoute 42,5 g d'une solution de p.toluène sulfonate de p.diazodiphénylamine condensé formaldéhyde à 6% dans le méthylcellosolve.

On applique cette solution sur une feuille de polyester traitée de façon suivante:

A l'aide d'une tournette à 200 t/mn pendant 30'', on applique une solution à 25% de résine phénol-formol ALNOVOL PM 430 dans le butanol, on sèche dans la tournette 5' à 40°C puis on sèche en étuve à 85°C pendant 5'.

Sur la feuille ainsi traitée, on enduit la solution photosensible dans la tournette à 50 t/mn pendant 30'' puis on sèche dans la tournette pendant 5' à 40°C, enfin on sèche en étuve à 85°C pendant 5'.

On expose la feuille dans les mêmes conditions que l'exemple 1.

On développe au jet d'eau dans les mêmes conditions que l'exemple 1.

On obtient un film bleu positif, sans aucun voile de colorant sur le film.

### Exemple 5

Film rouge:

On obtient dans les mêmes conditions que dans l'exemple 4 un film rouge en utilisant la même quantité de rhodamine B ou rhodamine 6G à la place du colorant bleu victoria. Les résultats obtenus sont identiques.

### Exemple 6

Film jaune:

On obtient dans les mêmes conditions que dans l'exemple 4 un film jaune en remplaçant le colorant bleu victoria par la même quantité d'Auramine OO de la Société R. A. L. UGINE-KUHLMAN.

Les résultats sont identiques.

### Exemple 7

Film bleu:

On prépare dans les mêmes conditions que l'exemple 4 une solution photosensible à 5% de solide dans le méthylcellosolve. On utilise le même colorant bleu.

On applique cette solution sur une feuille de polyester traité de la façon suivante: à l'aide d'une tournette à 200 t/mn pendant 30'', on applique une solution à 1% d'époxy cresol novolaque 1299 de CIBA GEIGY dans le méthylcellosolve, on sèche dans la tournette 5' à 40°C puis en étuve à 85°C pendant 5'.

Sur la feuille ainsi traitée on enduit la solu-/tion photosensible dans les mêmes conditions que l'exemple 4.

On expose la feuille dans les mêmes conditions que l'exemple 1. On développe au jet d'eau dans les mêmes conditions que l'exemple 1. Les résultats sont excellents et il n'y a aucun voile de colorant sur le film.

### Exemple 8

Film rouge:

On obtient dans les mêmes conditions que dans l'exemple 7 un film rouge de remplaçant le bleu victoria par la même quantité de colorant rhodamine B ou 6G.

Les résultats obtenus sont identiques.

### Exemple 9

Film jaune:

On obtient dans les mêmes conditions que dans l'exemple 7 un film jaune en utilisant ou remplaçant le bleu victoria par la même quantité de colorant d'Auramine OO.

On obtient des résultats identiques.

### Exemple 10

Couleur magenta:

On prépare une solution A photosensible à 5% de solide dans le méthylcellosolve. On dissout 2,5 g de résine époxy novolaque 1139 de la Société CIBA GEIGY, 0,125 g de Rhodamine B et 0,125 g de Rhodamine 6G extra de CIBA GEIGY dans 55,5 g de méthylcellosolve.

On ajoute à cette solution 42,5 g d'une solution de p.tolune sulfonate de p.diazo-diphénylamine condensé formaldéhyde à 6% dans le méthylcellosolve.

On prépare ensuite la solution de substrage B suivante, contenant 2,5% en poids de résine EPIKOTE 1001 de la Société SHELL en solution dans le méthylcellosolve.

Cette solution B est ensuite enduite en tournette sur une feuille de polyterephthalate d'éthylène, à 200 t/mn pendant 30'', puis séchée dans la tournette pendant 5 mn à 40°C et enfin séchée en étuve à 85°C pendant 5 mn.

Sur la feuille de polyester ainsi traitée, on applique A en tournette à 50 t/mn pendant 30'', puis on sèche cette couche 5 mn en tournette à 40°C et enfin 5 mn en étuve à 85°C.

On expose la feuille ainsi traitée à travers un montage négatif sous une lampe à arc du type NUARC 2 KW pendant 4 mn à une distance de 60 cm. On obtient une image visible violette en lumière blanche et en lumière inactinique.

L'auxiliaire visuel ainsi obtenu est ensuite développé au jet d'eau, en frottant légèrement avec un tampon. La qualité de la copie obtenue est excellente et il ne reste aucun voile de colorant sur le film. L'auxiliaire visuel obtenu est un excellent guide de couleur magneta.

### Exemple 11
Couleur bleue:

On opère comme dans l'exemple 10 en remplaçant les Rhodamines B et 6G par 0,25 g de bleu victoria BRN de la Société BASF.

Dans les mêmes conditions opératoires que dans l'exemple 10, on obtient les mêmes résultats. Le film obtenu, de couleur bleue, peut être utilisé comme film obtenu, de couleur bleue, peut être utilisé comme film de montage inactinique.

### Exemple 12
Couleur Jaune:

On opère dans les mêmes conditions que dans l'exemple 10 en remplaçant les rhodamines B et 6G par 0,20 g d'Auramine OO. En opérant comme dans l'exemple 10 (temps d'exposition: 5 mn, on obtient les mêmes résultats. Le film obtenu est jaune et peut être utilisé comme guide de couleur.

### Exemple 13
Couleur noire:

On opère comme dans l'exemple 10 en remplaçant les rhodamines B et 6G par le mélange de colorants suivants:

— 0,20 g de bleu victoria BRN de BASF
— 0,20 g de rouge de méthyle de la Société UGINE KUHLMAN
— 0,10 g d'auramine OO de la Société UGINE KUHLMAN

On opère ensuite comme dans l'exemple 10 (temps d'exposition: 5 mn).

On obtient un film noir positif pouvant être utilisé comme microfiche ou comme film de contretypage pour les Arts Graphiques.

### Exemple 14
Couleur noire:

On prépare la même solution que dans l'exemple 13, enduite dans les mêmes conditions sur un film polyterephtalate d'éthylène revêtu d'une couche de substratage obtenue par enduction d'une solution de résine EPON 1031 de la Société SHELL à 3,5% dans le méthylcellosolve, dans une tournette à 200 t/mn pendant 30''. La couche est ensuite séchée pendant 5 mn à 40°C en tournette puis pendant 5 mn et étuve à 85°C.

On opère ensuite comme dans l'exemple 13. Le film obtenu est noir et peut être utilisé comme film microfiche ou comme film de contretypage pour les Arts Graphiques.

### Exemple 15
Couleur noire:

On applique sur une feuille de polyterephtalate d'éthylène une solution de Plexigum PM 381 (polymétacrylate de méthyle et de butyle) de la Société ROHM et HAAS, à 2,5% dans l'acétate de méthylcellosolve. Cette enduction est réalisée comme précédemment en tournette à 200 t/mn pendant 30'', puis séchage pendant 5 mn en tournette à 40°C et enfin séchage en étuve pendant 5 mn à 80°C.

On opère ensuite comme dans l'exemple 14.

Le film obtenu a une densité optique de 1,5 et peut être utilisé comme film pour microfiches ainsi que comme film de contretypage pour les Arts Graphiques.

### Exemple 16
Film jaune:

On réalise la même solution photosensible que dans l'exemple 12. On applique cette solution sur un film substraté à l'aide de Plexigum PM 381 comme dans l'exemple 15, et dans les mêmes conditions opératoires.

On obtient également un excellent film positif jaune pouvant être utilisé comme guide de couleur.

### Revendications

1. Article pour la réalisation d'auxiliaires visuels comportant un support trnsparent et revêtu d'une composition photopolymérisable négative soluble dans les solvants organiques, constituée d'une résine époxyde et d'un produit de réaction photosensible résultant de la réaction entre:

— un produit de condensation photosensible et hydrosoluble lui-même obtenu par condensation entre un composé de diazonium et un agent de condensation organique possédant des groupes carbonyles réactifs,
— un agent de couplage organique caractérisé en ce que:
a) la résine époxy est un onomère ou un prépolymère fluide à température ambiante ayant un point de fusion déterminé selon la méthode de Durran inférieur ou égal à 38°C
b) l'agent de couplage organique est choisi de telle manière que le produit de réaction photosensible précipite au cours de sa préparation en milieu aqueux sous forme de pâte, ce qui entraine une légère solubilité dans l'eau du produit de réaction.

2. Article selon la revendication 1 caractérisé en ce que l'agent de couplage organique est un acide arylsulfonique éventuellement substitué.

3. Article selon la revendication 2 caractérisé en ce que le coefficient $\sigma$ de l'équation Hammet et relatif au substituant de l'acide arylsulfonique est négtif.

4. Article selon la revendication 3 caractérisé en ce que l'acide arylsulfonique comporte un ou plusieurs substituenats alkyl ou alkoxy.

5. Article selon la revendication 4 caractérisé en ce que les substituants de l'acide arylsulfonique sont choisis parmi H, $CH_3$ ou $C_2H_5$.

6. Article selon l'une des revendications 1 à 5 caractérisé en ce que l'agent de couplage organique est choisi parmi les acides benzènesulfonique, toluène-sulfonique ou 2,5 diméthyl benzène sulfonique.

7. Article selon l'une des revendications 1 à 6 caractérisé en ce que la résine époxy a un équivalent époxy inférieur à 200.

8. Article selon l'une des revendications 1 à 7 caractérisé en ce que le point de fusion de la résine époxy mesuré selon la méthode de Durran est inférieur ou égal à 27°C.

9. Article selon l'une des revendications 1 à 8 caractérisé en ce que le point de fusion de la résine époxy mesuré selon la méthode de Durran est inférieur ou égal à 20°C.

10. Article selon l'une des revendications 1 à 9 caractérisé en ce que la viscosité de la résine époxy est supérieure à 5000 centipoises à 25°C.

11. Article selon l'une des revendications 1 à 10 caractérisé en ce que la résine époxy est choisie parmi les éthers glycidiques du bisphénol A et/ou les résines époxy novolaques phénol ou crésol, utilisées seules ou en mélanges.

12. Article selon l'une des revendications 1 à 11 caractérisé en ce que la résine époxy est choisie parmi les éthers diglycidiques du bisphénol A.

13. Article selon l'une des revendications 1 à 12 caractérisé en ce que l'agent de condensation organique est un aldéhyde ou un acétal.

14. Article selon l'une des revendications 1 à 13 caractérisé en ce que l'agent de condensation organique est le formaldéhyde ou le paraformaldéhyde.

15. Article selon l'une des revendications 1 à 14 caractérisé en ce que le composé de diazonium est un diazo arylamine, éventuellement substitué.

16. Article selon l'une des revendications 1 à 15 caractérisé en ce que le composé de diazonium est choisi parmi la paradiazodiphénylamine et ses dérivés.

17. Article selon l'une des revendications 1 à 16 caractérisé en ce que la composition photopolymérisable comporte de 40% à 70% en poids de produit de réaction photosensible et de 30% à 60% en poids de résine époxy.

18. Article selon l'une des revendications 1 à 17 caractérisé en ce que la composition photopolymérisable comporte de 45% à 60% en poids de produit de réaction photosensible et de 40% à 55% en poids de résine époxy.

## Claims

1. Article for making visual aids, including a transparent substrate coated with a negative photopolymerisable composition soluble in organic solvents and consisting of an epoxide resin and of a photosensitive rection product resulting from the reaction of:
— a photosensitive and water-soluble condensation product, itself obtained by the condensation of a diazonium compound with an organic condensation agent possessing reactive carbonyl groups, with
— an organic coupling agent,
characterised in that:
a) the epoxy resin is a monomer or a prepolymer which is fluid at ambient temperature and which has a melting point, determined by Durran's method, which is less than or equal to 38°C, and
b) the organic coupling agent is chosen in such a way that the photosensitive reaction product precipitates in the course of its preparation, in an aqueous medium, in the form of a paste, which results in a slight solubility of the reaction product in water.

2. Article according to Claim 1, characterised in that the organic coupling agent is an optionally substituted arylsulphonic acid.

3. Article according to Claim 2, characterised in that the coefficient $\sigma$ in Hammett's equation, relating to the substituent of the arylsulphonic acid, is negative.

4. Article according to Claim 3, characterised in that the arylsulphonic acid contains one or more alkyl or alkoxy substituents.

5. Article according to Claim 4, characterised in that the substituents of the arylsulphonic acid are chosen from amongst H, $CH_3$ or $C_2H_5$.

6. Article according to one of Claims 1 to 5, characterised in that the organic coupling agent is chosen from amongst benzenesulphonic, toluenesulphonic or 2,5-dimethylbenzenesulphonic acids.

7. Article according to one of Claims 1 to 6, characterised in that the epoxy resin has an epoxy equivalent of less than 200.

8. Article according to one of Claims 1 to 7, characterised in that the melting point of the epoxy resin, measured by Durran's method, is less than or equal to 27°C.

9. Article according to one of Claims 1 to 8, characterised in that the melting point of the epoxy resin, measured by Durran's method, is less than or equal to 20°C.

10. Article according to one of Claims 1 to 9, characterised in that the viscosity of the epoxy resin is greater than 5,000 centipoises at 25°C.

11. Article according to one of Claims 1 to 10, characterised in that the epoxy resin is chosen from amongst the glycidyl ethers of bisphenol A and/or the phenol or cresol novolak epoxy resins used by themselves or in mixtures.

12. Article according to one of Claims 1 to 11, characterised in that the epoxy resin is chosen from amongst the diglycidyl ethers of bisphenol A.

13. Article according to one of Claims 1 to 12, characterised in that the organic condensation agent is an aldehyde or an acetal.

14. Article according to one of Claims 1 to 13, characterised in that the organic condensation agent is formaldehyde or paraformaldehyde.

15. Article according to one of Claims 1 to 14, characterised in that the diazonium compound is an optionally substituted diazoarylamine.

16. Article according to one of Claims 1 to 15, characterised in that the diazonium compound is chosen from amongst para-diazodiphenylamine and its derivatives.

17. Article according to one of Claims 1 to 16, characterised in that the photopolymerisable composition contains from 40% to 70% by weight of photosensitive reaction product and from 30% to 60% by weight of epoxy resin.

18. Article according to one of Claims 1 to 17, characterised in that the photopolymerisable composition contains from 45% to 60% by weight of photosensitive reaction product and from 40% to 55% by weight of epoxy resin.

## Patentansprüche

1. Gegenstand zur Herstellung von Hilfsansichten oder Hilfsdarstellungen, der einen transparenten Träger und eine Beschichtung aus einer photopolymerisierbaren negativ arbeitenden, in organischen Lösungsmitteln löslichen Zusammensetzung, bestehend aus einem Epoxydharz und einem lichtempfindlichen Reaktionsprodukt, welches sich bei der Umsetzung von

— einem lichtempfindlichen und wasserlöslichen Kondensationsprodukt, das selbst durch Kondensation zwischen einer Diazoniumverbindung und einem organischen, reaktionsfähige Carbonylgruppen enthaltenden Kondensationsmittel, erhalten wurde,

— und einem organischen Kupplungsmittel, ergibt, umgaßt, dadurch gekennzeichnet, daß

(a) das Epoxyharz ein bei Raumtemperatur fließfähiges monomeres oder vorpolymeres Epoxyharz mit einem Schmelzpunkt, bestimmt nach dem Verfahren von Durran, von unterhalb oder gleich 38°C ist, und

(b) das organische Kupplungsmittel in solcher Weise ausgewählt ist, daß das im Verlauf seiner Herstellung in einem wäßrigen Milieu in Form einer Paste ausgefallene lichtempfindliche Reaktionsprodukt von sich aus eine leichte mühelose Löslichkeit im Wasser (des Reaktionsproduktes) aufweist.

2. Gegenstand nach Anspruch 1, dadurch gekennzeichnet, daß organische Kupplungsmittel eine gegebenenfalls substituierte Arylsulfonsäure ist.

3. Gegenstand nach Anspruch 2, dadurch gekennzeichnet, daß der Koeffizient $\sigma$ der Hammet-Gleichung mit Bezug auf den Substituenten der Arylsulfonsäure negativ ist.

4. Gegenstand nach Anspruch 3, dadurch gekennzeichnet, daß die Arylsulfonsäure einen oder mehrere Alkyl- oder Alkoxysubstituenten trägt.

5. Gegenstand nach Anspruch 4, dadurch gekennzeichnet, daß die Substituenten der Arylsulfonsäure aus der Gruppe von H, $CH_3$ oder $C_2H_5$ ausgewählt sind.

6. Gegenstand nach einem der Ansprüche 1 bis 5, dadurch gekennzeichnet, daß das organische Kupplungsmittel aus der Gruppe von Benzolsulfonsäure, Toluolsulfonsäure und/oder 2,5-Dimethylbenzolsulfonsäure ausgewählt ist.

7. Gegenstand nach einem der Ansprüche 1 bis 6, dadurch gekennzeichnet, daß das Epoxyharz ein Epoxyäquivalent von unterhalb 200 aufweist.

8. Gegenstand nach einem der Ansprüche 1 bis 7, dadurch gekennzeichnet, daß der Schmelzpunkt des Epoxyharzes, gemessen nach dem Verfahren von Durran, unterhalb oder gleich 27°C ist.

9. Gegenstand nach einem der Ansprüche 1 bis 8, dadurch gekennzeichnet, daß der Schmelzpunkt des Epoxyharzes, gemessen nach dem Verfahren von Durran, unterhalb oder gleich 20°C ist.

10. Gegenstand nach einem der Ansprüche 1 bis 9, dadurch gekennzeichnet, daß die Viskosität des Epoxyharzes höher als 5000 Centipoise bei 25°C ist.

11. Gegenstand nach einem der Ansprüche 1 bis 10, dadurch gekennzeichnet, daß das Epoxyharz aus der Gruppe von Glycidinäthern von Bisphenol A und/oder Novolakepoxyphenol- oder Novolakepoxykresolharzen, verwendet allein oder in Form von Mischungen, gewählt ist.

12. Gegenstand nach einem der Ansprüche 1 bis 11, dadurch gekennzeichnet, daß das Epoxyharz aus der Gruppe von Diglycidinäthern von Bisphenol A ausgewählt ist.

13. Gegenstand nach einem der Ansprüche 1 bis 12, dadurch gekennzeichnet, daß das organische Kondensationsmittel ein Aldehyd oder ein Acetal ist.

14. Gegenstand nach einem der Ansprüche 1 bis 13, dadurch gekennzeichnet, daß das organische Kondensationsmittel Formaldehyd oder Paraformaldehyd ist.

15. Gegenstand nach einem der Ansprüche 1 bis 14, dadurch gekennzeichnet, daß die Diazoniumverbindung ein gegebenenfalls substituiertes Diazoarylamin ist.

16. Gegenstand nach einem der Ansprüche 1 bis 15, dadurch gekennzeichnet, daß die Diazoniumverbindung aus der Gruppe von Paradiazodiphenylamin und dessen Derivaten ausgewählt ist.

17. Gegenstand nach einem der Ansprüche 1 bis 16, dadurch gekennzeichnet, daß die photopolymerisierbare Zusammensetzung 40 bis 70 Gew.% eines lichtempfindlichen Reaktionsproduktes und 30 bis 60 Gew.% des Epoxyharzes umfaßt.

18. Gegenstand nach einem der Ansprüche 1 bis 17, dadurch gekennzeichnet, daß die photopolymerisierbare Masse 45 bis 60 Gew.% des lichtempfindlichen Reaktionsproduktes und 40 bis 55 Gew.% des Epoxyharzes umfaßt.